# EUROPEAN PATENT APPLICATION

(11) **EP 1 039 530 A2**
(43) Date of publication of application: **27.09.2000**
(21) Application number: 00104654.9
(22) Date of filing: 03.03.2000
(51) Int. Cl.: H01L 21/768

(54) **Method for manufacturing semiconductor device capable of avoiding flaws and erosion caused by metal chemical-mechanical polishing process**

(30) Priority: 05.03.1999 JP 5794799
(71) Applicant: NEC CORPORATION, Tokyo (JP)
(72) Inventor: Takaharu, Kunugi, c/o NEC Corporation, Tokyo (JP)
(74) Representative: Glawe, Delfs, Moll & Partner

(57) **Abstract**

In a method for manufacturing a semiconductor device, a first conductive layer (3) is formed above a semiconductor substrate (1), an insulating layer (4) is formed on the first conductive layer, and a sacrifice layer (11) is formed on the insulating layer. Then, a hole (PH) is perforated in the sacrifice layer and the insulating layer. Then, a second conductive layer (5,6) is formed on the sacrifice layer and within the hole. Then, a metal chemical mechanical polishing operation is performed upon the second conductive layer to expose the sacrifice layer. Finally, the sacrifice layer is removed. Alternatively, a barrier metal layer may be provided in the hole and on the insulating layer, instead of forming the sacrifice layer. In both methods, scratches (X) caused by the metal chemical mechanical polishing are removed together with the sacrifice layer or the barrier metal layer.

## Description

### BACKGROUND OF THE INVENTION

### Field of the Invention

The present invention relates to a method for manufacturing a semiconductor device capable of avoiding flaws or scratches and erosion caused by a metal chemical mechanical polishing ("metal CMP") process.

### Description of the Related Art

CMP processes are popularly used in planarizing interlayers or insulating layers of semiconductor devices. This is because miniaturized semiconductor devices are required to be perfectly planarized as the exposure margin is reduced as a result of the design rules adapted to the semiconductor devices that require beams of light with a shorter wavelength for exposure in order to obtain finer patterns. Such CMP processes are called "oxide CMP" processes.

On the other hand, CMP processes are used to planarize metal layers made of tungsten (W), aluminum (Al) or copper (Cu) buried in plug holes or grooves in order to prepare semiconductor devices showing a quality level higher than those prepared by conventional etching back processes. These CMP processes are called "metal CMP" processes.

The "metal CMP" processes are applied to a damascene method for forming a wiring layer and a dual-damascene method for forming a plug and a wiring layer on the plug at the same time.

Thus, CMP processes are indispensable for the manufacture of high performance semiconductor devices.

In CMP processes, note that the polishing agent is adjusted to carry out an "oxide CMP" process or a "metal CMP" process. In the "oxide CMP" process, the polishing rate of insulating material such as silicon oxide is larger than that of metal. On the other hand, in the "metal CMP" process, the polishing rate of metal is larger than that of insulating material such as silicon oxide.

In a prior art method for manufacturing a semiconductor device, an insulating layer is formed on a first conductive layer above a semiconductor substrate. Then, a hole is perforated in the insulating layer, and a second conductive layer is formed on the insulating layer and within the hole. Then, a "metal CMP" process is performed upon the second conductive layer to expose the insulating layer. This will be explained later in detail.

In the above-described prior art method, however, flaws or scratches are inevitably generated on the surface of the insulating layer, which may invite short-circuit or disconnection of wiring layers formed on the insulating layer. This would reduce the manufacturing yield. Also, the erosion effect is remarkably exhibited, which may cause the parasitive capacitance of the insulating layer within the device to fluctuate. This would deteriorate the reliability. This will also be explained later in detail.

In order to remove the above-mentioned flaws or scratches, an additional "oxide CMP" process can be performed upon the insulating layer after the "metal CMP" process is performed (see JP-A-10-189602). In this case, however, flaws or scratches are nevertheless generated on the surface of the insulating layer as a result of the "oxide CMP" process, although the number of flaws or scratches becomes smaller. Also, the additional CMP process increases the manufacturing cost. Further, since CMP processes generate more surface defects or dirt particles than other comparable processes mainly because of the above-mentioned flaws or scratches and the fact that abrasive grains of the polishing agent, metal particles and the like cannot be perfectly removed by a cleaning process after the CMP processes. Thus, the use of such an additional "oxide CMP" process is not highly effective for preventing flaws or scratches from being generated by the "metal CMP" process.

### SUMMARY OF THE INVENTION

It is an object of the present invention to provide a method for manufacturing a semiconductor device capable of avoiding flaws and erosion by a "metal CMP" process.

According to the present invention, in a method for manufacturing a semiconductor device, a first conductive layer is formed above a semiconductor substrate, an insulating layer is formed on the first conductive layer, and a sacrifice layer is formed on the insulating layer. Then, a hole is perforated in the sacrifice layer and the insulating layer. Then, a second conductive layer is formed on the sacrifice layer and within the hole. Then, a "metal CMP" operation is performed upon the second conductive layer to expose the sacrifice layer. Finally, the sacrifice layer is removed. Thus, flaws or scratches on the surface of the sacrifice layer generated by the "metal CMP" operation are completely removed, and also, the thickness of the insulating layer remains uniform.

Also, in a method for manufacturing a semiconductor device, a first conductive layer is formed above a semiconductor substrate, and an insulating layer is formed on the first conductive layer. Then, a hole is perforated in the insulating layer. Then, a barrier metal layer and a metal layer are sequentially formed on the insulating layer and within the hole. Then, a "metal CMP" operation is performed upon the metal layer to expose the barrier metal layer. Finally, the exposed portion of the barrier metal layer is removed. Thus, flaws or scratches on the surface on the barrier metal layer generated by the "metal CMP" operation are completely removed, and also, the thickness of the insulating layer remains uniform.

### BRIEF DESCRIPTION OF THE DRAWINGS

The present invention will be more clearly understood from the description set forth below, as compared with the prior art, with reference to the accompanying drawings, wherein:
Figs. 1A through 1F are cross-sectional views for explaining a prior art method for manufacturing a semiconductor device;
Fig. 2 is a plan view of the device of Fig. 1F;
Fig. 3 is a cross-sectional view for explaining the erosion effect in the device obtained by the method as illustrated in Figs. 1A through 1F;
Figs. 4A through 4G are cross-sectional views for explaining a first embodiment of the method for manufacturing a semiconductor device according to the present invention;
Fig. 5 is a plan view of the device of Fig. 4G;
Figs. 6A and 6B are cross-sectional views for explaining the erosion effect in the device obtained by the method as illustrated in Figs. 4A through 4G;
Figs. 7A through 7I are cross-sectional views illustrating a modification of Figs. 4A through 4G;
Figs. 8A through 8G are cross-sectional views for explaining a second embodiment of the method for manufacturing a semiconductor device according to the present invention;
Figs. 9A through 9G are cross-sectional views for explaining a third embodiment of the method for manufacturing a semiconductor device according to the present invention; and
Fig. 10 is a cross-sectional view of the device of Fig. 4G.

### DESCRIPTION OF THE PREFERRED EMBODIMENTS

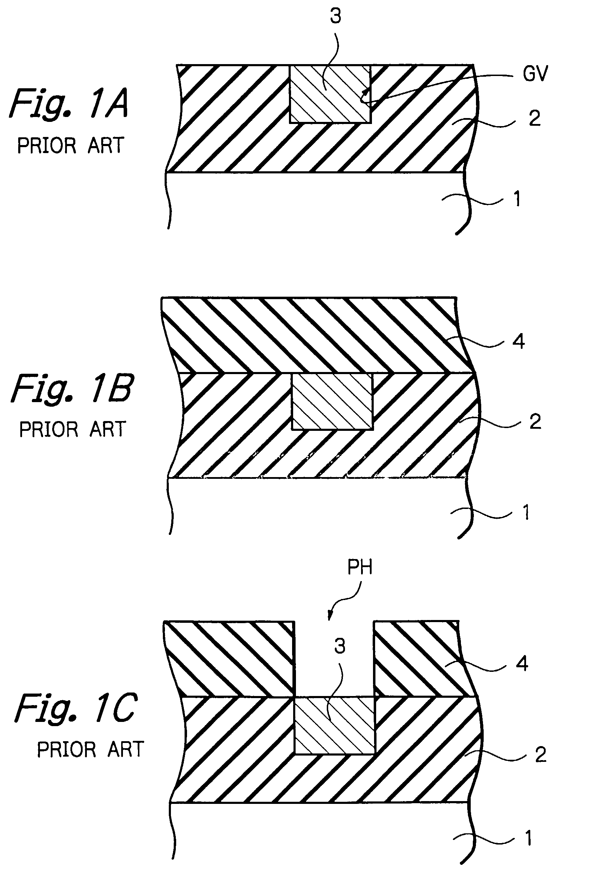

Before the description of the preferred embodiments, a prior art method for manufacturing a semiconductor device will be explained with reference to Figs. 1A through 1F, 2 and 3.

First, referring to Fig. 1A, an insulating layer 2 made of silicon oxide is deposited on a semiconductor substrate 1 by a chemical vapor deposition (CVD) process. Then, a groove GV is perforated in the insulating layer 2 by a photolithography and dry etching process. Then, a conductive layer 3 made of tungsten (W), aluminum (Al) or copper (Cu) is buried in the groove GV of the insulating layer 2. In this case, the conductive layer 3 serves as a lower wiring layer.

Next, referring to Fig. 1B, an insulating layer 4 made of silicon oxide is deposited on the entire surface by a CVD process.

Next, referring to Fig. 1C, a plug hole PH is perforated in the insulating layer 4 by a photolithography and dry etching process.

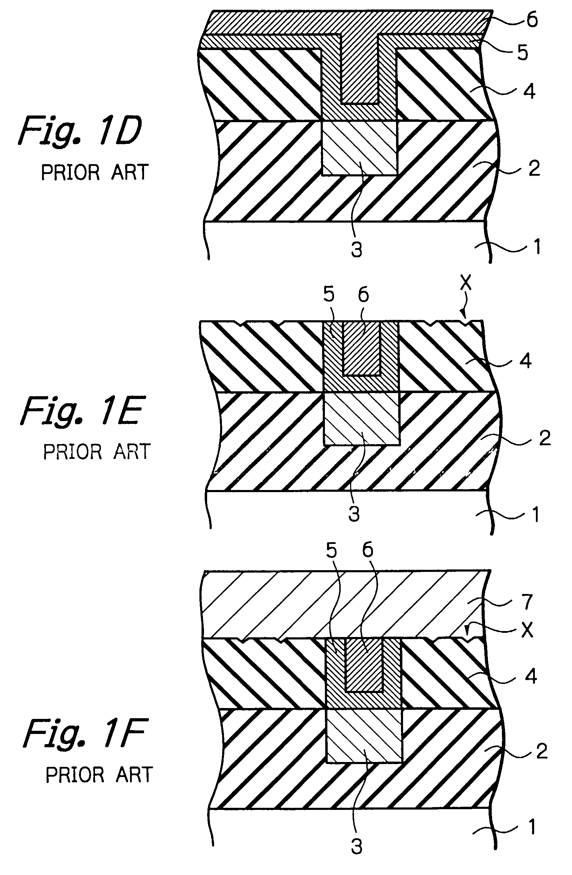

Next, referring to Fig. 1D, a barrier metal layer 5 made of titanium (Ti) or titanium nitride (TiN) and a metal layer 6 made of W, Al, Cu, or a multilayer or an alloy of two or more metals are sequentially deposited on the entire surface by a sputtering process.

Note that the barrier metal layer 5 compensates for the poor contact characteristics between the insulating layer 4 and the metal layer 6. Also, the barrier metal layer 5 has good coverage characteristics and good contact resistance characteristics.

Next, referring to Fig. 1E, the metal layer 6 and the barrier layer 5 are flattened by a "metal CMP" process using the insulating layer 4 as a stopper.

Generally, a CMP process uses a polishing agent including abrasives formed by about 0.1 to 1 micron meter abrasive grains made of alumina or silica, an oxidizer made of potassium iodide solution or hydrogen peroxide water, and a pH adjuster. Also, the viscosity of the polishing agent is adjusted. Therefore, when the back face of a semiconductor wafer is chucked to the bottom face of a polishing head made of polyurethane, and then the polishing head with the semiconductor wafer is rotated and pushed onto a rotating polishing cloth onto which the above-mentioned polishing liquid is dripped, the front face of the semiconductor wafer is flattened by the physical effect of friction caused by the abrasives that are brought into contact with the surface of the wafer and the chemical effect caused by the oxidizer or the like. Also, in the "metal CMP" process, note that the size of the abrasive grains is relatively large, so that the polishing rate of the barrier metal layer 5 and the metal layer 6 is larger that of the insulating layer 4. Therefore, the insulating layer 4 serves as a stopper in the "metal CMP" process.

Finally, referring to Fig. 1F, an insulating layer made of silicon oxide (not shown) is deposited on the entire surface by a CVD process, and a groove (not shown) is perforated in the insulating layer by a photolithography and dry etching process. Then, a conductive layer 7 made of W or the like is buried in the groove. The conductive layer 7 serves as an upper wiring layer.

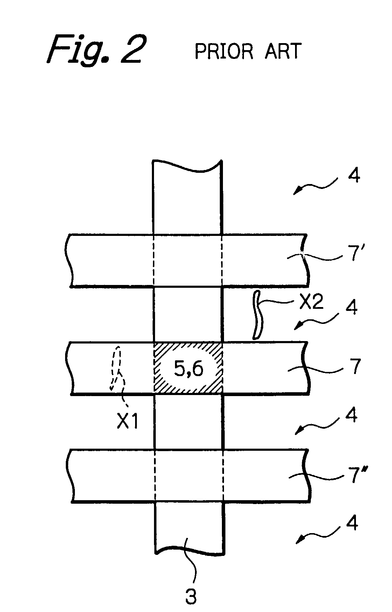

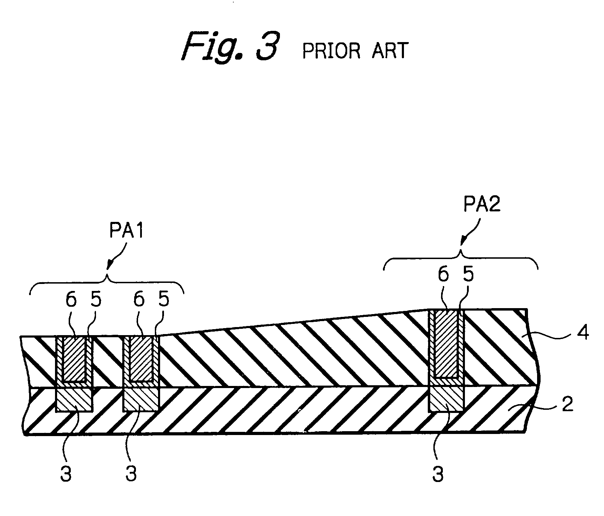

In the method as illustrated in Figs. 1A through 1F, however, since the abrasive grain size is relatively large, flaws or scratches X as indicated in Figs. 1E and 1F are inevitably generated on the surface of the insulating layer 4. These flaws or scratches would short-circuit or disconnect upper wiring layers. That is, as illustrated in Fig. 2, which is a plan view of Fig. 1F, the conductive layer 7 (upper wiring layer) as well as its adjacent conductive layers 7' and 7" crosses over the conductive layer 3 (lower wiring layer). In this case, the conductive layer 7 is electrically connected via a plug formed by the barrier metal layer 5 and the metal layer 6 to the conductive layer 3, while there is no electrical connection between the conductive layers 7' and 7" and the conductive layer 3. Therefore, if a flaw or scratch as indicated by X1 in Fig. 2 is generated, the conductive layer 7 would be disconnected. Also, if a flaw or scratch as indicated by X2 in Fig. 2 is generated and metal is buried in the flaw or scratch, the conductive layers 7 and 7' would be short-circuited. This would reduce the manufacturing yield.

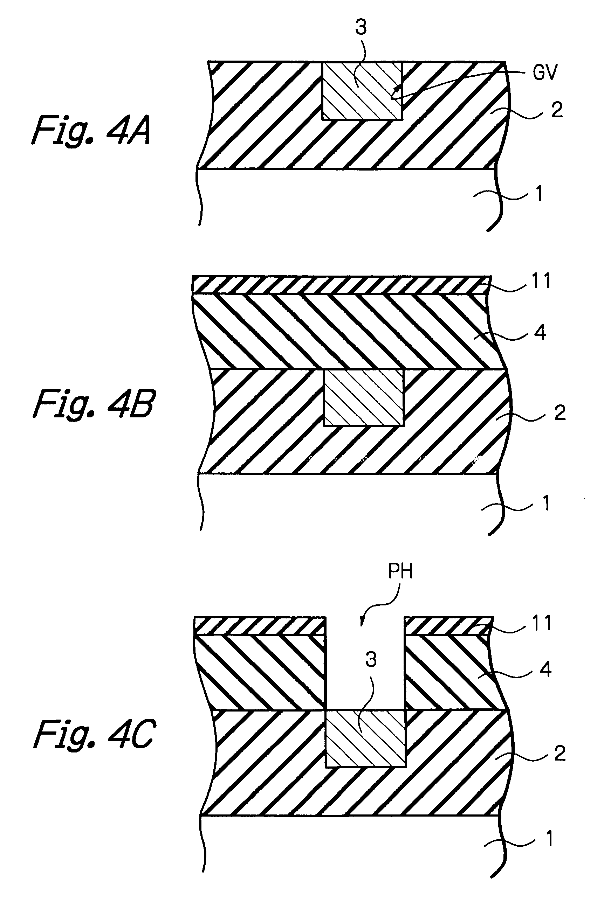

Also, in the method as illustrated in Figs. 1A through 1F, the erosion effect is remarkably exhibited, which would fluctuate the parasitic capacitance of the wiring layers. That is, in the "metal CMP" process, in order to completely remove the barrier metal layer 5 and the metal layer 6 on the insulating layer 4, the barrier metal layer 5 and the metal layer 6 are overpolished. However, in this case, as illustrated in Fig. 3, the polishing rate of the barrier metal layer 5 and the metal layer 6 is larger in a tight pattern area PA1 than in a coarse pattern area PA2 since the stopping effect of the insulating layer 4 is larger in the coarse pattern area PA2 than in the tight pattern area PA2. As a result, the thickness of the insulating layer 4 fluctuates within the device, so that the parasitive capacitance of the insulating layer 4 fluctuates within the device, which would deteriorate the reliability.

A first embodiment of the method for manufacturing a semiconductor device according to the present invention will be explained next with reference to Figs. 4A through 4G, 5, 6A and 6B.

First, referring to Fig. 4A, in the same way as in Fig. 1A, an insulating layer 2 made of silicon oxide is deposited on a semiconductor substrate 1 by a CVD process. Then, a groove GV is perforated in the insulating layer 2 by a photolithography and dry etching process. Then, a conductive layer 3 made of W, Al or Cu is buried in the groove .GV of the insulating layer 2. In this case, the conductive layer 3 serves as a lower wiring layer.

Next, referring to Fig. 4B, an about 500 nm thick insulating layer 4 made of silicon oxide is deposited on the entire surface by a CVD process. Subsequently, an about 50 nm thick sacrifice layer 11 made of silicon nitride (Si₃N₄) is deposited on the insulating layer 4 by a CVD process.

Next, referring to Fig. 4C, an about 500 nm diameter plug hole PH is perforated in the sacrifice layer 11 and the insulating layer 4 by a photolithography and dry etching process.

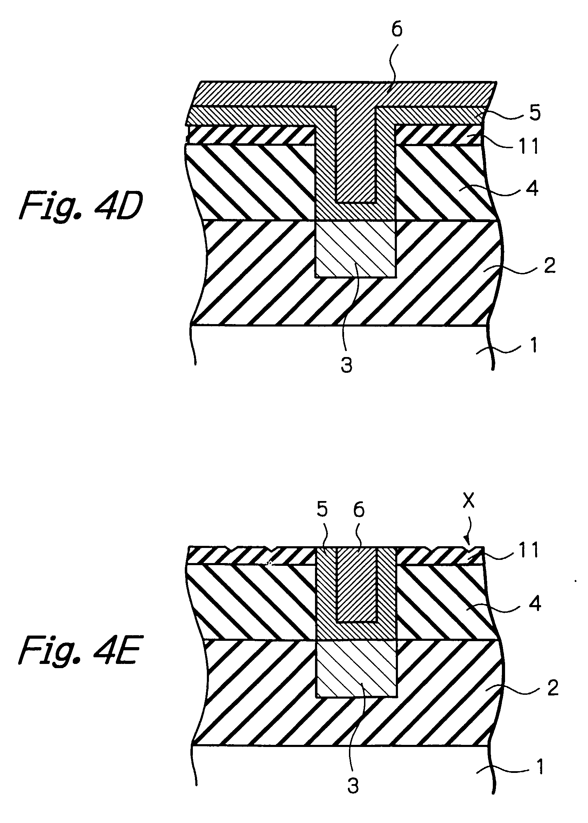

Next, referring to Fig. 4D, in the same way as in Fig. 1D, an about 30 nm thick barrier metal layer 5 made of Ti or TiN and an about 600 nm thick metal layer 6 made of W, Al, Cu, or a multilayer or an alloy of two or more metals are sequentially deposited on the entire surface by a sputtering process.

Next, referring to Fig. 4E, the metal layer 6 and the barrier layer 5 are flattened by a "metal CMP" process using the sacrifice layer 11 as a stopper.

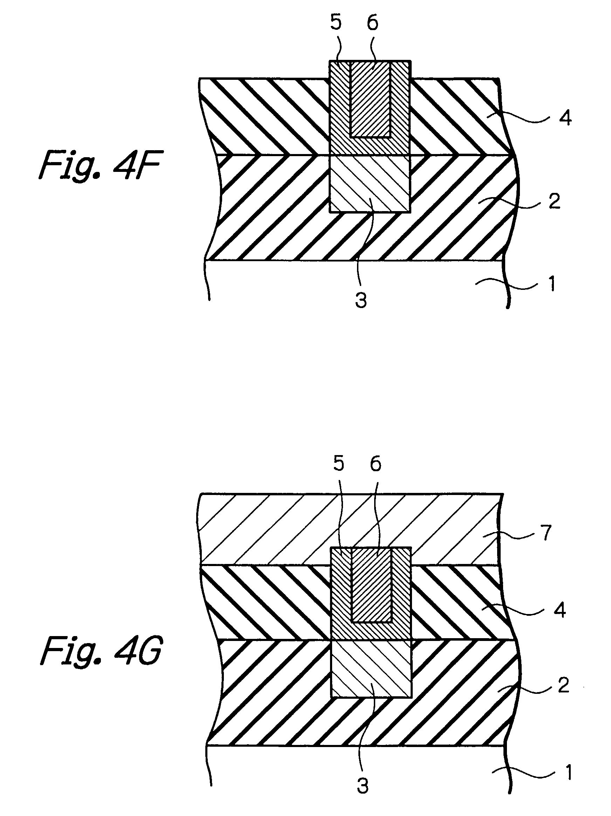

Next, referring to Fig. 4F, the sacrifice layer 11 is removed by a wet etching process using a phosphoric acid solution.

Finally, referring to Fig. 4G, in the same way as in Fig. 1F, an insulating layer made of silicon oxide (not shown) is deposited on the entire surface by a CVD process, and a groove (not shown) is perforated in the insulating layer by a photolithography and dry etching process. Then, a conductive layer 7 made of W or the like is buried in the groove. The conductive layer 7 serves as an upper wiring layer.

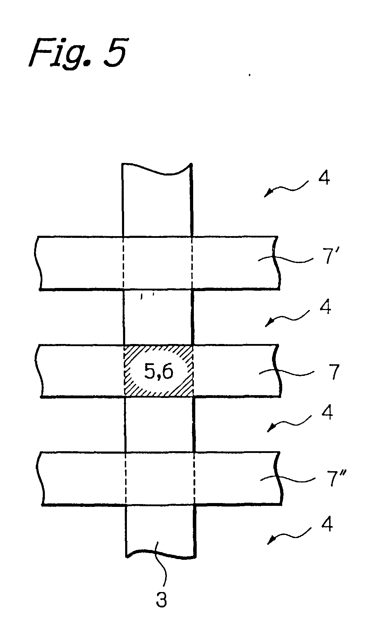

Even in the method as illustrated in Figs. 4A through 4G, since the abrasive grain size is relatively large, flaws or scratches X as indicated in Fig. 4E are inevitably generated on the surface of the sacrifice layer 11. However, these flaws or scratches X are completely removed simultaneously with the removal of the sacrifice layer 11, so that the insulating layer 4 is prevented from being damaged. Therefore, as illustrated in Fig. 5, the upper wiring layers 7, 7' and 7" are never short-circuited or disconnected by the flaws or scratches X. This would improve the manufacturing yield.

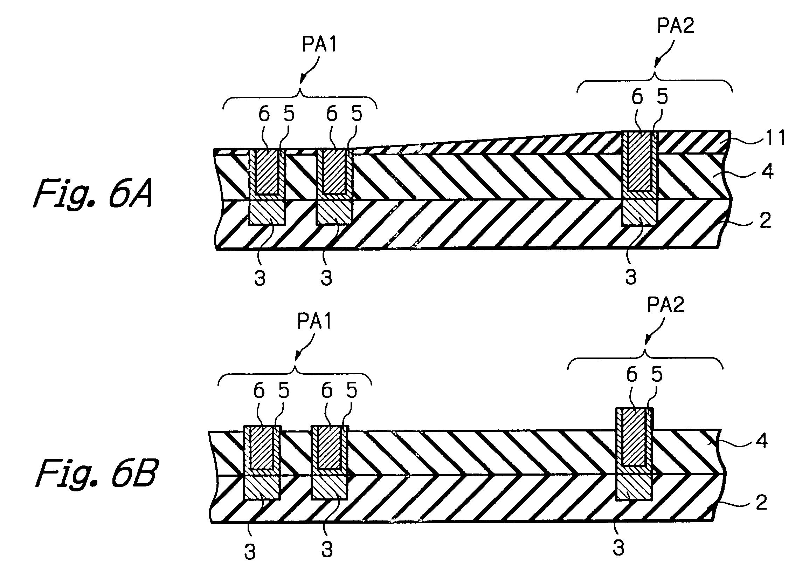

Also, in the method as illustrated in Figs. 4A through 4G, the erosion effect is hardly exhibited, which would not cause the parasitic capacitance of the wiring layers to fluctuate. That is, in the "metal CMP" process, in order to completely remove the barrier metal layer 5 and the metal layer 6 on the insulating layer 4, the barrier metal layer 5 and the metal layer 6 are overpolished. Therefore, in this case, as illustrated in Fig. 6A, the polishing rate of the barrier metal layer 5 and the metal layer 6 is larger in a tight pattern area PA1 than in a coarse pattern area PA2 since the stopping effect of the sacrifice layer 11 is larger in the coarse pattern area PA2 than in the tight pattern area PA2. As a result, the thickness of the sacrifice layer 11 fluctuates within the device. However, as illustrated in Fig. 6B, after the sacrifice layer 11 is removed, the thickness of the insulating layer 4 remains uniform, so that the parasitive capacitance of the insulating layer 4 hardly fluctuates within the device. Thus, the device is not structurally affected, which would not deteriorate the reliability.

In the first embodiment as illustrated in Figs. 4A through 4G, the sacrifice layer 11 made of Si₃N₄ can be etched by an anisotropic dry etching process using a mixture gas of CHF₃ and O₂.

Also, the sacrifice layer 11 can be made of silicon oxide nitride (SiON), polycrystalline silicon, Al, Ti or TiN. If SiON is used, it may be etched by a wet etching process using a mixture solution of sulfuric acid and hydrogen peroxide or an anisotropic dry etching process using a mixture gas of CHF₃/O₂. If polycrystalline silicon is used, it may be etched by a wet etching process using a mixture solution of fluoric acid and acetic acid or a dry etching process using a gas of HBr. If Al is used, it may be etched by a wet etching process using a mixture solution of nitric acid, acetic acid and phosphoric acid or a dry etching process using a gas of chlorine (Cl₂). If Ti or TiN is used, it may be etched by a wet etching process using a mixture solution of sulfuric acid and hydrogen peroxide with a mixing ratio of 4∼5 to 1.

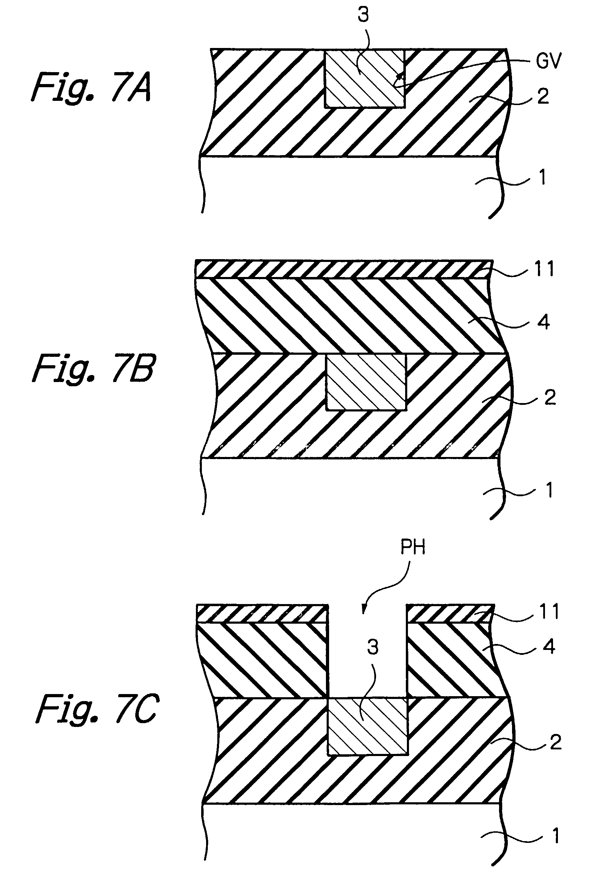

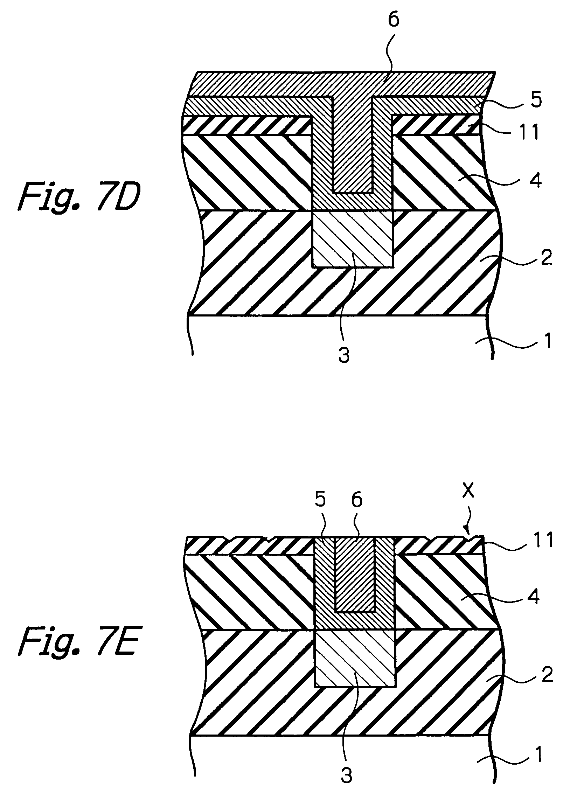

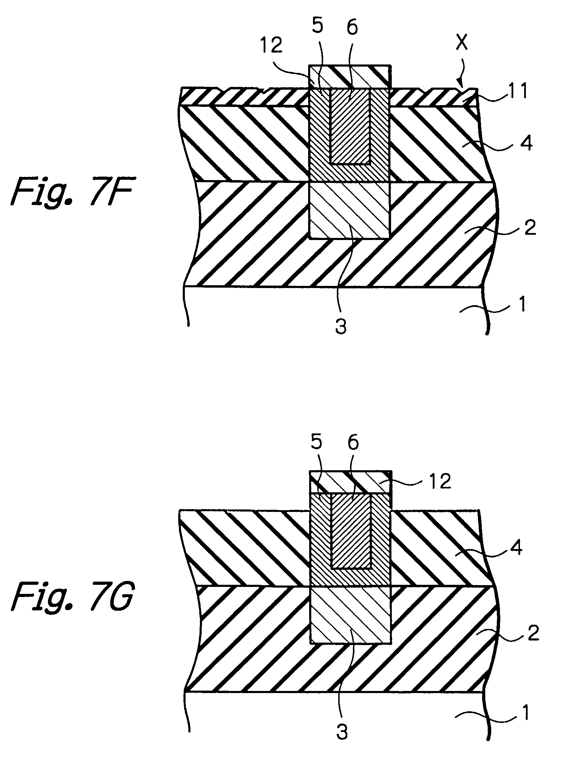

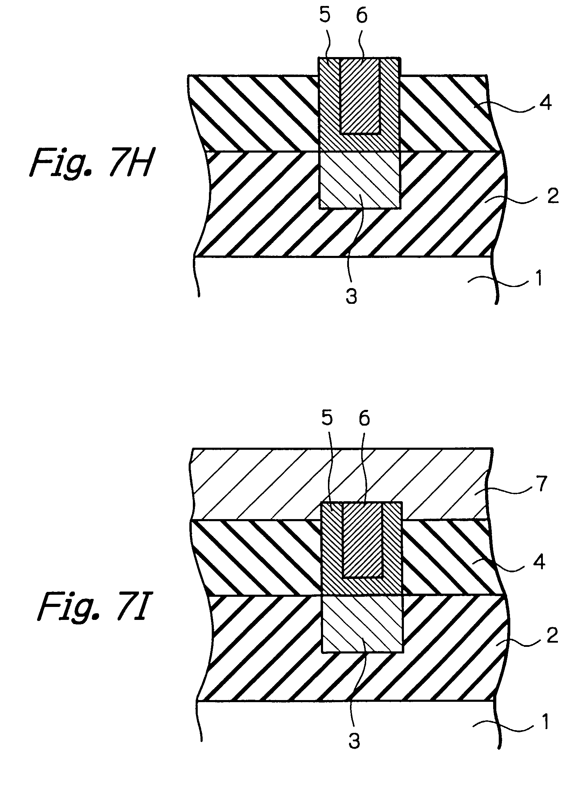

In Figs. 7A through 7I, which illustrate a modification of the first embodiment, Figs. 7A, 7B, 7C, 7D, 7E, 7H and 7I correspond to Figs. 4A, 4B, 4C, 4D, 4E, 4F and 4G, respectively, and the steps of Figs. 7F and 7G are added to the steps of the first embodiment. That is, after the "metal CMP" process is carried out at the step of Fig. 7E corresponding to Fig. 4E, the manufacturing process proceeds to a step as illustrated in Fig. 7F.

Referring to Fig. 7F, a protection layer 12 made of photoresist is formed only on the plug formed by the barrier metal layer 5 and the metal layer 6 by a photolithography process.

Next, referring to Fig. 7G, the sacrifice layer 11 is removed by a wet etching process or an anisotropic dry etching process as in the first embodiment. In this case, since the surface of the barrier metal layer 5 and the metal layer 6 is protected by the protection layer 12, the barrier metal layer 5 and the metal layer 6 are prevented from being etched or transformed. Then, the protection layer 12 is removed to obtain the device as illustrated in Fig. 7H.

A second embodiment of the method for manufacturing a semiconductor device according to the present invention will be explained next with reference to Figs. 8A through 8G.

First, referring to Fig. 8A, in the same way as in Fig. 4A, an insulating layer 2 made of silicon oxide is deposited on a semiconductor substrate 1 by a CVD process. Then, a groove GV is perforated in the insulating layer 2 by a photolithography and dry etching process. Then, a conductive layer 3 made of W, Al or Cu is buried in the groove GV of the insulating layer 2. In this case, the conductive layer 3 serves as a lower wiring layer.

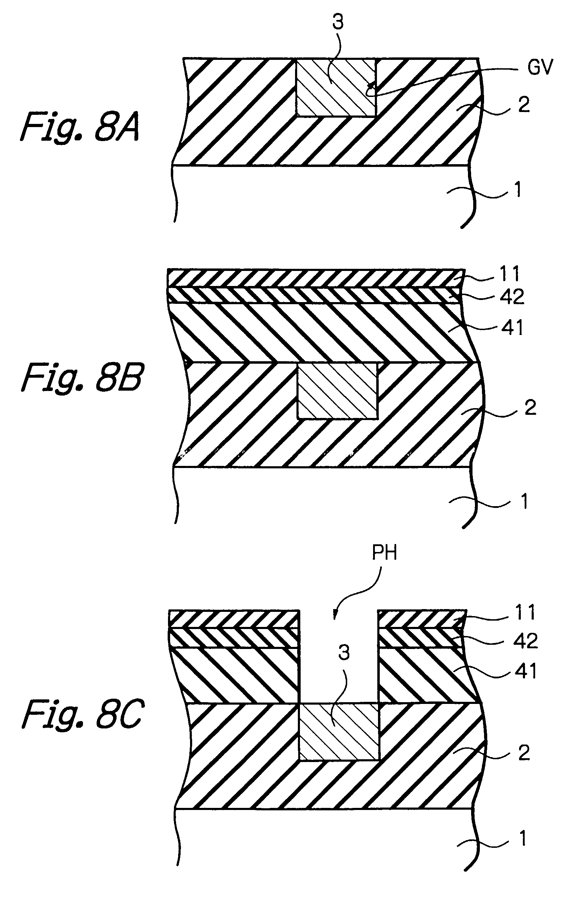

Next, referring to Fig. 8B, an about 300 nm thick insulating layer 41 made of silicon oxide and an about 200 nm thick insulating layer 42 made of normal silicated glass (NSG) are deposited on the entire surface by a CVD process. Subsequently, an about 50 nm thick sacrifice layer 11 made of boron phospho-silicated glass (BPSG) is deposited on the insulating layer 42 by a CVD process.

Next, referring to Fig. 8C, in a similar way to those of Fig. 4C, an about 500 nm diameter plug hole PH is perforated in the sacrifice layer 11 and the insulating layers 41 and 42 by a photolithography and dry etching process.

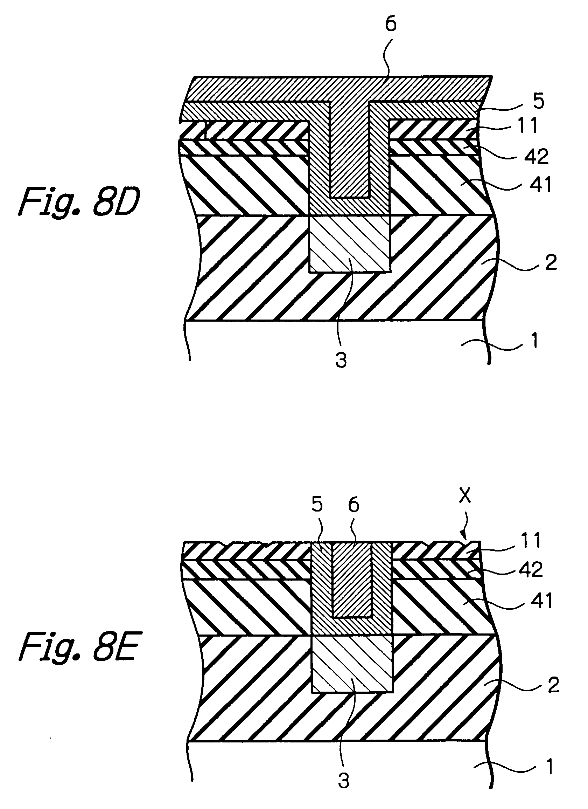

Next, referring to Fig. 8D, in the same way as in Fig. 4D, an about 30 nm thick barrier metal layer 5 made of Ti or TiN and an about 600 nm thick metal layer 6 made of W, Al, Cu, or a multilayer or an alloy of two or more metals are sequentially deposited on the entire surface by a sputtering process.

Next, referring to Fig. 8E, in the same way as in Fig. 4E, the metal layer 6 and the barrier layer 5 are flattened by a "metal CMP" process using the sacrifice layer 11 as a stopper.

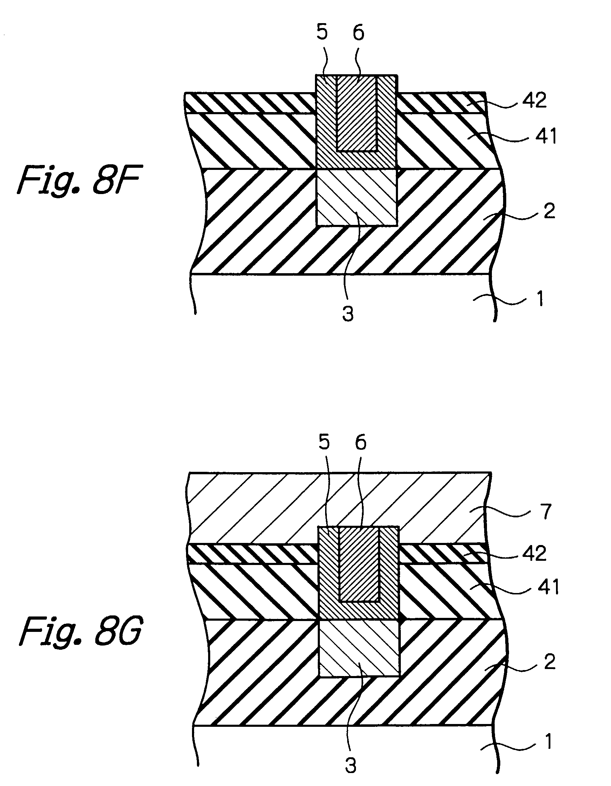

Next, referring to Fig. 8F, the sacrifice layer 11 is removed by a wet etching process using a mixture solution of fluoric acid and ammonium fluoride. In this wet etching process, the etching selectivity of the sacrifice layer 11 is enhanced.

Finally, referring to Fig. 8G, in the same way as in Fig. 4F, an insulating layer made of silicon oxide (not shown) is deposited on the entire surface by a CVD process, and a groove (not shown) is perforated in the insulating layer by a photolithography and dry etching process. Then, a conductive layer 7 made of W or the like is buried in the groove. The conductive layer 7 serves as an upper wiring layer.

Even in the method as illustrated in Figs. 8A through 8G, since the abrasive grain size is relatively large, flaws or scratches X as indicated in Fig. 8E are inevitably generated on the surface of the sacrifice layer 11. However, these flaws or scratches X are completely removed simultaneously with the removal of the sacrifice layer 11, so that the insulating layer 42 is prevented from being damaged. Therefore, the upper wiring layers are never short-circuited or disconnected by the flaws or scratches X. This would improve the manufacturing yield.

Also, in the method as illustrated in Figs. 8A through 8G, the erosion effect is hardly exhibited, which would not cause the parasitic capacitance of the wiring layers. Thus, the device is not structurally affected, which would not deteriorate the reliability.

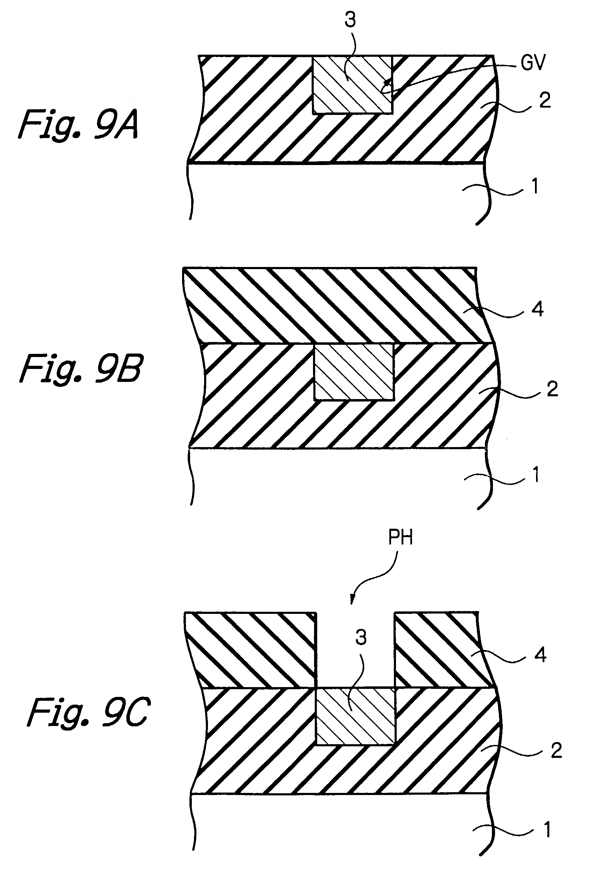

A third embodiment of the method for manufacturing a semiconductor device according to the present invention will be explained next with reference to Figs. 9A through 9G.

First, referring to Fig. 9A, in the same way as in Fig. 1A, an insulating layer 2 made of silicon oxide is deposited on a semiconductor substrate 1 by a CVD process. Then, a groove GV is perforated in the insulating layer 2 by a photolithography and dry etching process. Then, a conductive layer 3 made of W, Al or Cu is buried in the groove GV of the insulating layer 2. In this case, the conductive layer 3 serves as a lower wiring layer.

Next, referring to Fig. 9B, in the same way as in Fig. 1B, an about 500 nm thick insulating layer 4 made of silicon oxide is deposited on the entire surface by a CVD process. Subsequently, an about 50 nm thick sacrifice layer 11 made of silicon nitride (Si₃N₄) is deposited on the insulating layer 4 by a CVD process.

Next, referring to Fig. 9C, in the same way as in Fig. 1C, an about 500 nm diameter plug hole PH is perforated in the insulating layer 4 by a photolithography and dry etching process.

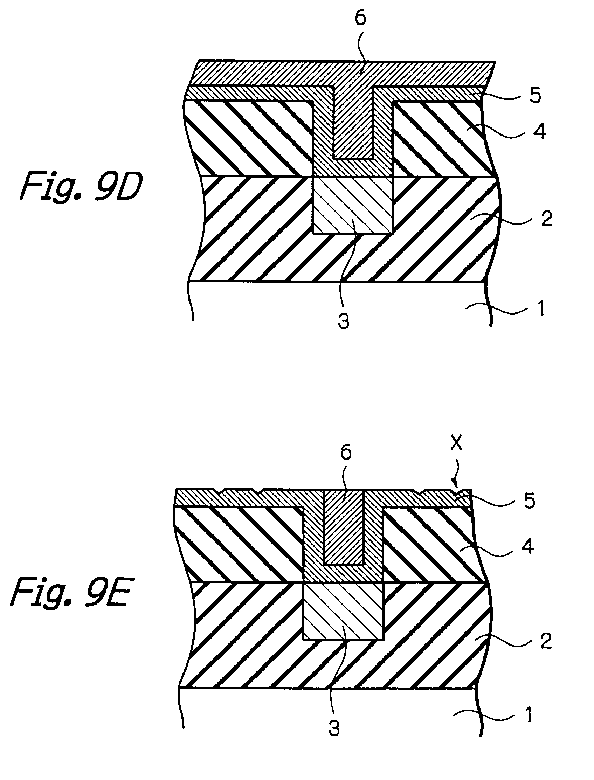

Next, referring to Fig. 9D, in the same way as in Fig. 1D, an about 30 nm thick barrier metal layer 5 made of Ti or TiN and an about 600 nm thick metal layer 6 made of W, Al, Cu, or a multilayer or an alloy of two or more metals are sequentially deposited on the entire surface by a sputtering process.

Next, referring to Fig. 9E, the metal layer 6 is flattened by a "metal CMP" process, to expose the barrier metal layer 5.

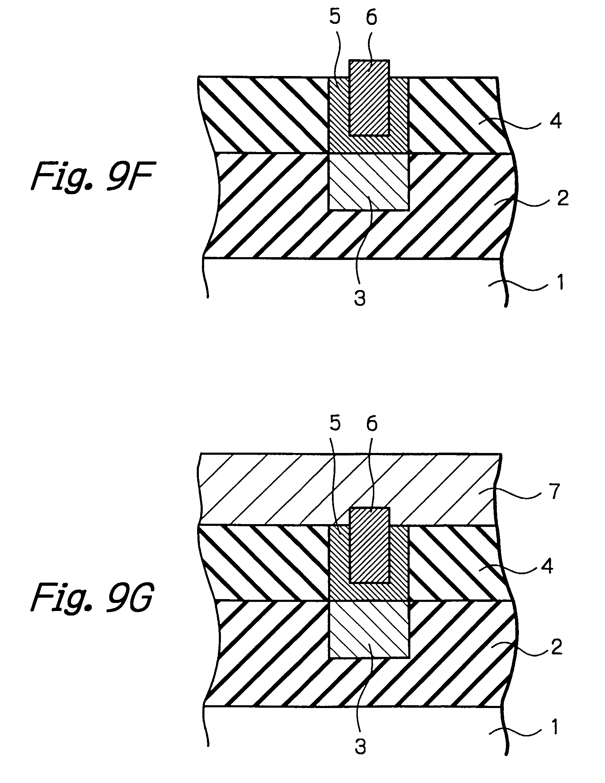

Next, referring to Fig. 9F, the barrier metal layer 5 is removed by a wet etching process using a mixture solution of sulfuric acid and hydrogen peroxide with a mixing ratio of 4∼5 to 1 or a dry etching process using Cl₂ gas.

Finally, referring to Fig. 9G, in the same way as in Fig. 1F, an insulating layer made of silicon oxide (not shown) is deposited on the entire surface by a CVD process, and a groove (not shown) is perforated in the insulating layer by a photolithography and dry etching process. Then, a conductive layer 7 made of W or the like is buried in the groove. The conductive layer 7 serves as an upper wiring layer.

Even in the method as illustrated in Figs. 9A through 9G, since the abrasive grain size is relatively large, flaws or scratches X as indicated in Fig. 9E are inevitably generated on the surface of the barrier metal layer 5. However, these flaws or scratches X are completely removed simultaneously with the removal of the barrier metal layer 5, so that the insulating layer 4 is prevented from being damaged. Therefore, as illustrated in Fig. 9F, the upper wiring layers are never short-circuited or disconnected by the flaws or scratches X. This would improve the manufacturing yield.

Also, in the method as illustrated in Figs. 9A through 9G, the erosion effect is hardly exhibited, which would not cause the parasitic capacitance of the wiring layers to fluctuate. Thus, the device is not structurally affected, which would not deteriorate the reliability.

In the above-described embodiments, although the upper surface of the conductive layer 3 is on the same level with the upper surface of the insulating layer 2, the former may alternatively be located above the latter or vice versa. Also, although the conductive layer 3 and the plug formed by the barrier metal layer 5 and the metal layer 6 have the same width, the width of the conductive layer 3 may be smaller than that of the plug or vice versa.

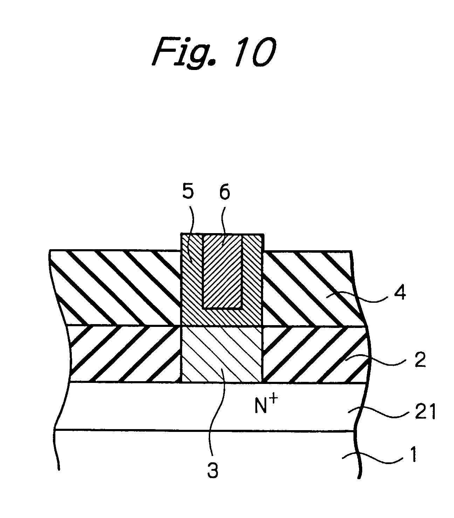

Also, in the above-described embodiments, although the barrier metal layer 5 and the metal layer 6 form a plug, the barrier metal layer 5 and the metal layer 6 may form an upper wiring layer where the plug hole PH serves as a groove for the upper wiring layer. In this case, as illustrated in Fig. 10 which is a modification of Fig. 4G, the conductive layer 3 serves as a plug between the upper wiring layer (5, 6) and a lower wiring layer 21 which may be made of an impurity diffusion region formed within the silicon substrate 1, or a conductive layer formed on the silicon substrate 1.

As explained hereinabove, according to the present invention, since the flaws or scratches that may be formed on the surface of the device as a result of a "metal CMP" process can be totally eliminated, the short-circuit or disconnection of the wiring layers can be avoided, which would enhance the manufacturing yield. Also, since the erosion effect due to the "metal CMP" process is hardly exhibited, the reliability of the device is not deteriorated.

## Claims

1. A method for manufacturing a semiconductor device, comprising the steps of:
forming a first conductive layer (3) above a semiconductor substrate (1);
forming a first insulating layer (4) on said first conductive layer;
forming a sacrifice layer (11) on said first insulating layer;
perforating a hole (PH) in said sacrifice layer and said first insulating layer;
forming a second conductive layer (5, 6) on said sacrifice layer and within said hole;
performing a metal chemical mechanical polishing operation upon said second conductive layer to expose said sacrifice layer; and
removing said sacrifice layer after said metal chemical mechanical polishing operation is performed.

2. The method as set forth in claim 1, wherein said sacrifice layer is made of silicon nitride,
said sacrifice layer removing step carrying out a wet etching process using phosphoric acid solution.

3. The method as set forth in claim 1, wherein said sacrifice layer is made of silicon nitride,
said sacrifice layer removing step carrying out an anisotropic dry etching process using a mixture gas of CHF₃ and O₂.

4. The method as set forth in claim 1, wherein said sacrifice layer is made of silicon oxide nitride,
said sacrifice layer removing step carrying out a wet etching process using a mixture solution of sulfuric acid and hydrogen peroxide.

5. The method as set forth in claim 1, wherein said sacrifice layer is made of silicon oxide nitride,
said sacrifice layer removing step carrying out an anisotropic dry etching process using a mixture gas of CHF₃ and O₂.

6. The method as set forth in claim 1, wherein said sacrifice layer is made of polycrystalline silicon,
said sacrifice layer removing step carrying out a wet etching process using a mixture solution of fluoric acid and acetic acid.

7. The method as set forth in claim 1, wherein said sacrifice layer is made of polycrystalline silicon,
said sacrifice layer removing step carrying out a dry etching process using a gas of HBr.

8. The method as set forth in claim 1, wherein said sacrifice layer is made of aluminum,
said sacrifice layer removing step carrying out a wet etching process using a mixture solution of nitric acid, acetic acid and phosphoric acid.

9. The method as set forth in claim 1, wherein said sacrifice layer is made of aluminum,
said sacrifice layer removing step carrying out a dry etching process using a gas of chlorine.

10. The method as set forth in claim 1, wherein said sacrifice layer is made of titanium,
said sacrifice layer removing step carrying out a wet etching process using a mixture solution of sulfuric acid and hydrogen peroxide.

11. The method as set forth in claim 1, wherein said sacrifice layer is made of titanium nitride,
said sacrifice layer removing step carrying out a wet etching process using a mixture solution of sulfuric acid and hydrogen peroxide.

12. The method as set forth in claim 1, further comprising the steps of:
forming a second insulating layer (2) on said semiconductor substrate; and
perforating a groove (GV) in said second insulating layer,
said first conductive layer forming step burying said first conductive layer in said groove.

13. The method as set forth in claim 1, wherein said hole is a plug hole,
said second conductive layer forming a plug.

14. The method as set forth in claim 13, further comprising a step of forming a third conductive layer (7) on said plug after said sacrifice layer is removed.

15. The method as set forth in claim 1, wherein said hole is a groove, said first conductive layer serving as a plug, said second conductive layer serving as a wiring layer.

16. The method as set forth in claim 1, further comprising a step of forming a protection layer (5) only on said second conductive layer after said metal chemical mechanical polishing operation is performed and before said sacrifice layer is removed.

17. The method as set forth in claim 16, wherein said protection layer is made of photoresist.

18. The method as set forth in claim 1, wherein said first insulating layer forming step comprises the steps of:
forming a silicon oxide layer (41) on said first conductive layer; and
forming a normal silicated glass layer (42) on said silicon oxide layer.

19. The method as set forth in claim 18, wherein said sacrifice layer is made of boron silicated glass,
said sacrifice layer removing step carrying out a wet etching process using a mixture solution of fluoric acid and ammonium fluoride.

20. The method as set forth in claim 1, wherein said second conductive layer is a stacked layer of barrier metal and metal, said barrier metal being made of one of titanium and titanium nitride, said metal being made of one of tungsten, aluminum and copper.

21. A method for manufacturing a semiconductor device, comprising the steps of:
forming a first conductive layer (3) above a semiconductor substrate (1);
forming a first insulating layer (4) on said first conductive layer;
perforating a hole (PH) in said first insulating layer;
forming a barrier metal layer (5) on said first insulating layer and within said hole;
forming a metal layer (6) on said barrier metal layer;
performing a metal chemical mechanical polishing operation upon said metal layer to expose said barrier metal layer; and
removing an exposed portion of said barrier metal layer after said metal chemical mechanical polishing operation is performed.

22. The method as set forth in claim 21, further comprising the steps of:
forming a second insulating layer (2) on said semiconductor substrate; and
perforating a groove (GV) in said second insulating layer,
said first conductive layer forming step burying said first conductive layer in said groove.

23. The method as set forth in claim 21, wherein said hole is a plug hole,
said second conductive layer forming a plug.

24. The method as set forth in claim 23, further comprising a step of forming a second conductive layer (7) on said plug after the exposed portion of said barrier metal layer is removed.

25. The method as set forth in claim 21, wherein said hole is a groove, said first conductive layer serving as a plug, said barrier metal layer and said metal layer serving as a wiring layer.

26. The method as set forth in claim 21, wherein said barrier metal is made of one of titanium and titanium nitride, said metal being made of one of tungsten, aluminum and copper.

27. The method as set forth in claim 26, wherein said barrier metal layer removing step carrios out a wet etching process using a mixture solution of sulfuric acid and hydrogen peroxide.

28. The method as set forth in claim 26, wherein said barrier metal layer removing step carries out a dry etching process using chlorine gas.
